# EUROPEAN PATENT APPLICATION

(11) **EP 4 030 625 A1**
(43) Date of publication of application: **20.07.2022**
(21) Application number: 21151752.9
(22) Date of filing: 15.01.2021
(51) Int. Cl.: H03K 19/00, G11C 13/00, H01L 45/00

(54) **LOGIC CIRCUIT WITH VOLTAGE-CONTROLLED THRESHOLD SWITCH**

(71) Applicant: ETH Zurich, 8092 Zurich (CH)
(72) Inventor: CHENG, Bojun, 8006 Zurich (CH); LUISIER, Mathieu, 1934 Le Châble (CH); LEUTHOLD, Jürg, 8165 Oberweningen (CH)

(57) **Abstract**

A logic circuit (1, 1', ...) comprises at least two transistors (pFET, nFET) which are configured for providing a logic function, and at least one voltage-controlled threshold switch (M), which is arranged in at least one of the pull-up path and the pull-down path of at least one of the at least two transistors (pFET, nFET).

## Description

### FIELD OF THE INVENTION

The present invention relates to a logic circuit with a voltage-controlled threshold switch.

### BACKGROUND ART

Logic circuits such as CMOS (complementary metal-oxide-semiconductor) circuits include logic gates such as inverters or NOTs, NANDs (Not AND), NORs (Not OR), etc., or a combination thereof for providing adders, ring oscillators, etc. Reducing power consumption in logic circuits is highly important in various applications, such as in the field known as Internet of Things (IoT; cf. Shi et al., "The promise of edge computing", Computer, vol. 49, no. 5, pp. 78-81, 2016), in the field of portable embedded systems (PeS; cf. Dreslinski et al., "Near-threshold computing: Reclaiming moore's law through energy efficient integrated circuits", Proceedings of the IEEE, vol. 98, no. 2, pp. 253-266, 2010), etc. Particularly, reduced power consumption enables improving battery lifetime.

As regards IoT, chips including a sensor and a control circuit often operate at sampling rates below 1 kHz (cf. Harpe et al., "A 0.20 mm2 3 nW Signal Acquisition IC for Miniature Sensor Nodes in 65 nm CMOS," IEEE Journal of Solid-State Circuits, vol. 51, no. 1, pp. 240-248, 2015). The leakage (static) power consumption between two consecutive events can be significant, compared to the dynamic power consumption.

As regards PeS, circuits may operate at a sub- or near-threshold supply voltage (Vdd), which improves the energy efficiency of field-effect transistors (FETs) in a quadratic way, however at the cost of increased delay and lowered speed.

Shukla et al., "A steep-slope transistor based on abrupt electronic phase transition", Nature communications, vol. 6, no. 1, pp. 1-6, 2015 discloses a hyper-FET (hybrid-phase-transition-FET) with subthreshold swing (sub 60 mV/dec). A phase change material (insulator-to-metal transition material, IMT) is electrically integrated in series with the source of a conventional MOSFET (Metal-Oxide-Semiconductor Field-Effect Transistor) enabling steep switching.

Valov et al., "Electrochemical metallization memories--fundamentals, applications, prospects", Nanotechnology, vol. 22, no. 25, p. 254003, Jun 24 2011 discloses filament-based threshold switching, also known as conductive bridging random access memories (CBRAM)-type memristors, which offer steep switching, low switching voltage, low energy consumption, high ON/OFF rations and small footprint.

Song et al., "Steep slope field-effect transistors with Ag/TiO 2-based threshold switching device", IEEE Electron Device Letters, vol. 37, no. 7, pp. 932-934, 2016 and Cheng et al., "Ultra-steep-slope transistor enabled by an atomic memristive switch" (SPIE Nanoscience + Engineering), SPIE, 2020 disclose hybrid-FETs with filament-based threshold switching with a subthreshold swing of below 5 mV/dec.

Avedillo et al., "Phase transition FETs for improved dynamic logic gates," IEEE Electron Device Letters, vol. 39, no. 11, pp. 1776-1779, 2018 and Aziz et al., "Steep switching hybrid phase transition FETs (hyper-FET) for low power applications: A device-circuit co-design perspective-Part II", IEEE Transactions on Electron Devices, vol. 64, no. 3, pp. 1358-1365, 2017 disclose improvements in speed and power consumption of steep-slope hyper-FETs, for example having arranged a phase change material at the source of FETs.

WO2017111894A1 discloses a transistor having a gate electrode, a source electrode, and a drain region, and a threshold switch adjacent to one of the source or drain regions, wherein the threshold switch is a multilayer device having chalcogenide material. Described is a transistor having a gate electrode, a source electrode, and a drain region, and a threshold switch adjacent to a metal layer which is adjacent to one of the source or drain regions through one or more layers of contact/via and metal, wherein the threshold switch is a multilayer device with one of the layers being chalcogenide-based alloy.

US20190109177A1 discloses a steep-switch vertical field effect transistor. A semiconductor fin is formed vertically extending from a bottom source or drain region of a substrate. A top source or drain region is formed on a surface of the semiconductor fin and a top metallization layer is formed on the top source or drain region. A bi-stable resistive system is formed on the top metallization layer. The bi-stable resistive system includes an insulator-to-metal transition material or a thresholds-switching selector. A subthreshold switching slope of less than 60 millivolts per decade is provided.

US20140166957A1 discloses a hybrid circuit with a nitride-based transistor portion and a memristor portion. The transistor includes a source and a drain and a gate. The memristor includes a first electrode and a second electrode separated by an active switching region. The source or the drain of the transistor forms one of the electrodes of the memristor.

### DISCLOSURE OF THE INVENTION

There may be a need for an improved logic circuit avoiding some drawbacks of the prior art. More particularly, there may be a need for an improved logic circuit with reduced static power consumption. More particularly, there may be a need for an improved logic circuit operating at a sub- or near-threshold supply voltage with less cost of increased delay and lowered speed. More particularly, there may be a need for an improved logic circuit having improved current characteristics, such as reduced leakage currents. More particularly, there may be a need for an improved logic circuit which is robust with respect to large variances of transistor characteristics and circuit load, in particular circuit capacitive load. More particularly, there may be a need for an improved logic circuit which enables hysteresis free operation. More particularly, there may be a need for an improved logic circuit having a consistent input-output voltage relationship, regardless of previous voltage values. More particularly, there may be a need for an improved logic circuit with an output voltage that is robust regarding transistor variations and/or variations of the capacitive load of the circuit.

Such a need may be met with the subject-matter of the independent claims. Advantageous embodiments are defined in the dependent claims.

Ideas underlying embodiments of the present invention may be interpreted as being based, inter alia, on the following observations and recognitions.

An aspect of the invention relates to a logic circuit, comprising at least two transistors which are configured for providing a logic function, and at least one voltage-controlled threshold switch, which is arranged in at least one of the pull-up path and the pull-down path of at least one of the at least two transistors. The at least two transistors may relate to p-type field effect transistors/n-type field effect transistors which are arranged for providing a logic function such as a NOT function, a NAND function, a NOR function, etc. The at least one voltage-controlled threshold switch is configured for switching between a high resistance state and a low resistance state depending on the applied voltage. By arranging the voltage-controlled threshold switch in the pull-up path and/or in the pull-down path, leakage current can be reduced. By arranging a threshold switch which is voltage-controlled, and engineer its threshold switching voltage, high resistance state and low resistance state accordingly, robust operation is achieved which is independent on transistor variations and/or capacitive load.

In some embodiments, at least one of the at least one voltage-controlled threshold switch is configured for changing its state from a high resistance state (HRS) to a low resistance state (LRS) when the applied voltage is higher than a first predefined voltage. In particular, with increasing applied voltage, at the first predefined voltage the state changes from high resistance to low resistance.

In some embodiments, at least one of the at least one voltage-controlled threshold switch is configured for changing its state from a low resistance state (LRS) to a high resistance state (HRS) when the applied voltage is lower than a second predefined threshold voltage. In particular, with decreasing applied voltage, at the second predefined voltage the state changes from low resistance to high resistance.

When the threshold switch is in the high resistance state, reduced leakage is achieved. When the threshold switch is in the low resistance state, robust and high speed operation of the logic circuit is achieved. In particular, the first threshold voltage is higher than the second threshold voltage.

In some embodiments, at least one of the at least one voltage-controlled threshold switch is configured for maintaining over a range of applied currents an essentially constant voltage. When the threshold switch is in its low resistance state, voltage drop at the threshold switch is essentially constant and independent from the current passing through the threshold switch, thereby enabling robust operation of the logic function provided by the at least two transistors.

In some embodiments, the threshold switch includes a conductive filament structure which is configured for adapting to a current through the threshold switch for retaining an essentially constant voltage over the threshold switch. In some embodiments, the filament structure is configured for adapting its diameter to a current through the threshold switch.

In some embodiments, voltage-controlled threshold switch includes a stack of an active layer arranged between a first electrode and a second electrode. The active layer is in particular an oxide-based layer, a nitride layer, a two-dimensional hexagonal boron nitride layer, a solid-state electrolyte, or a combination of the mentioned layers. In case of an oxide-based layer, the active layer is selected from a material which includes in particular silicon dioxide, tantalum oxide, tungsten oxide, hafnium oxide or titanium oxide. In case of a nitride-based layer, the active layer is selected from a material which includes in particular a stack of titanium nitride and aluminum nitride and titanium nitride, a stack of titanium nitride and aluminum nitride and aluminum, or a stack of tantalum nitride and gallium aluminum nitride and aluminum. In case of a sold-state electrolyte, the active layer is selected from a material which includes a polymer, e.g. poly(ethylene oxide) (PEO), poly(vinylidene fluoride) (PVDF), polyacrylonitrile (PAN), and poly(methyl methacrylate) (PMMA) as the backbone to fill in the previously mentioned oxides. An oxide-based layer has the advantage of ease of integration into a CMOS fabrication process, good performance in terms of device to device and cycle to cycle variance, low switch voltage, high switching speed, long endurance, etc.

In some embodiment, the voltage-controlled threshold switch includes a stack of an active layer arranged between a first electrode and a second electrode. The first electrode and/or the second electrode includes a material which is selected from silver, copper, tungsten, cobalt, platinum and/or alloys thereof. The materials enable ease of integration into CMOS fabrication process, good performance in terms of device to device and cycle to cycle variance, low switch voltage, high switching speed, long endurance, etc. and are adapted for various semi-conductor technologies.

In some embodiments, the voltage-controlled threshold switch includes a resistive switching device, in particular a conductive-bridging-random-access-memory-type memristor (CBRAM) or another electrochemical metallization memory (ECM) device or a valence change mechanism (VCM) device. Robust operation of the voltage-controlled threshold switch is enabled.

In some embodiments, the voltage-controlled threshold switch includes a 3D structure (3D: three dimensional) comprising an electrode having a 3D tip for confining operation of the threshold switch or an insulating layer with a hole in particular in the form of a 2D layer (2D: two dimensional). Leakage current path is further reduced to occur at the apex of the 3D structure, where a thin layer of switching matrix is present. The reduced area also reduces significantly the leakage current.

In some embodiments, the voltage-controlled threshold switch includes silver-doped hafnium dioxide, copper / hafnium dioxide, silver / titanium dioxide, copper sulfide, silver / amorphous silicon, silver telluride / titanium nitride / titanium dioxide / titanium nitride, wolfram / copper sulfide and combinations thereof.

In some embodiments, the voltage-controlled threshold switch comprises an unipolar, abrupt, reversible, and electrically triggered resistance switch between two stable resistance states.

In some embodiments, the voltage-controlled threshold switch has an active area of less than 20 nm x 20 nm. The 20 nm x 20 nm is the size in x-y plane, which guarantees that the voltage-controlled threshold switch does not take too much area. Thickness of the active layer varies depending on the embodiment. In other embodiments, the size of the active area is smaller or larger.

In some embodiments, the circuit is configured for providing a hysteresis free operation. The threshold voltage is engineered to match the supply voltage of the transistors. The HRS and LRS of the voltage-controlled threshold switch is engineered to match the off-state resistance and the on-state resistance of the transistors.

In some embodiments, the circuit is configured for providing a NOT logic function and in particular comprises a p-type field effect transistor and a n-type field effect transistor.

In some embodiments, the circuit is configured for providing a NAND logic function or a NOR logic function and in particular comprises at least two p-type field effect transistors and at least two n-type field effect transistors.

The invention also relates to a plurality of circuits as described above and configured for providing a ring oscillator or an adder.

The invention also relates to an Internet-of-Things device or a near threshold computing device including one or more circuits as described above.

### BRIEF DESCRIPTION OF THE DRAWINGS

In the following, advantageous embodiments of the invention will be described with reference to the enclosed drawings. However, neither the drawings nor the description shall be interpreted as limiting the invention.
Fig. 1 illustrates the circuit diagram of a logic circuit in the form of an inverter;
Fig. 1(a) illustrates the circuit symbol of the inverter illustrated in Fig. 1;
Fig. 2(a) illustrates the Vm-I switching cycle with applied voltage of a threshold switch in accordance with some embodiments of the invention;
Fig. 2(b) illustrates the Vm-I diagram with applied current of a threshold switch in accordance with some embodiments of the invention;
Fig. 3 illustrates measured current/voltage diagrams and circuit diagrams of a inverter in accordance with some embodiments of the invention;
Fig. 4 illustrates simulated current/voltage diagrams and circuit diagrams of a inverter in accordance with some embodiments of the invention;

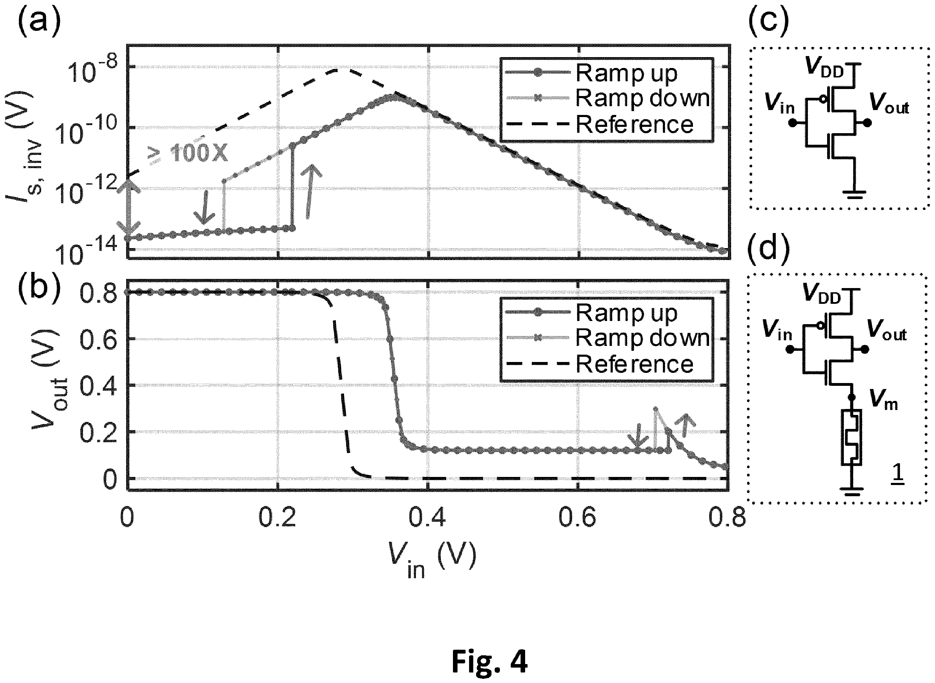

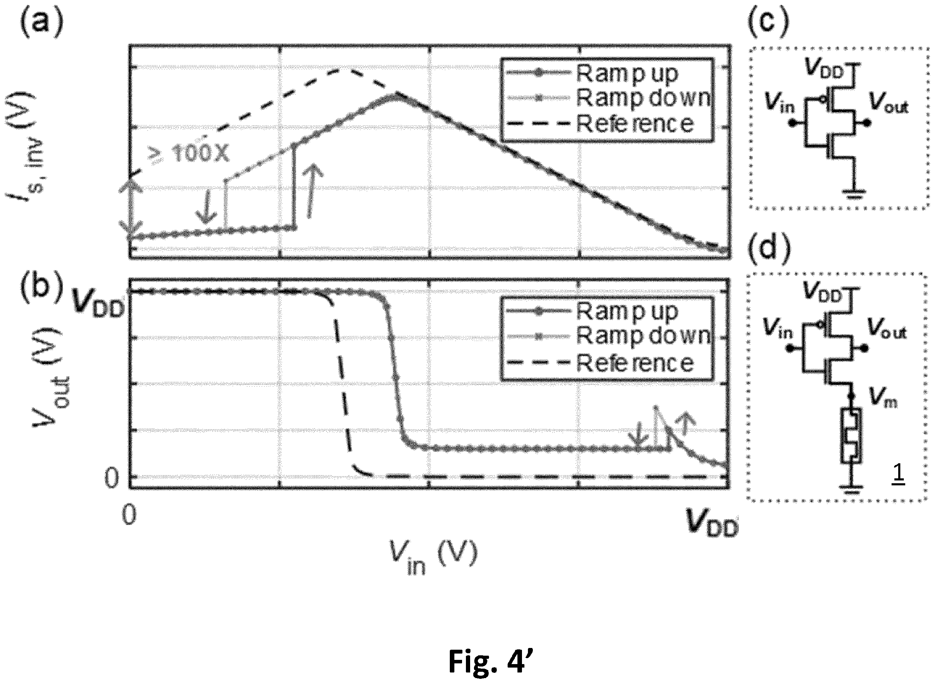

Fig. 4' illustrates current/voltage diagrams and circuit diagrams of a logic circuit in accordance with some embodiments of the invention;

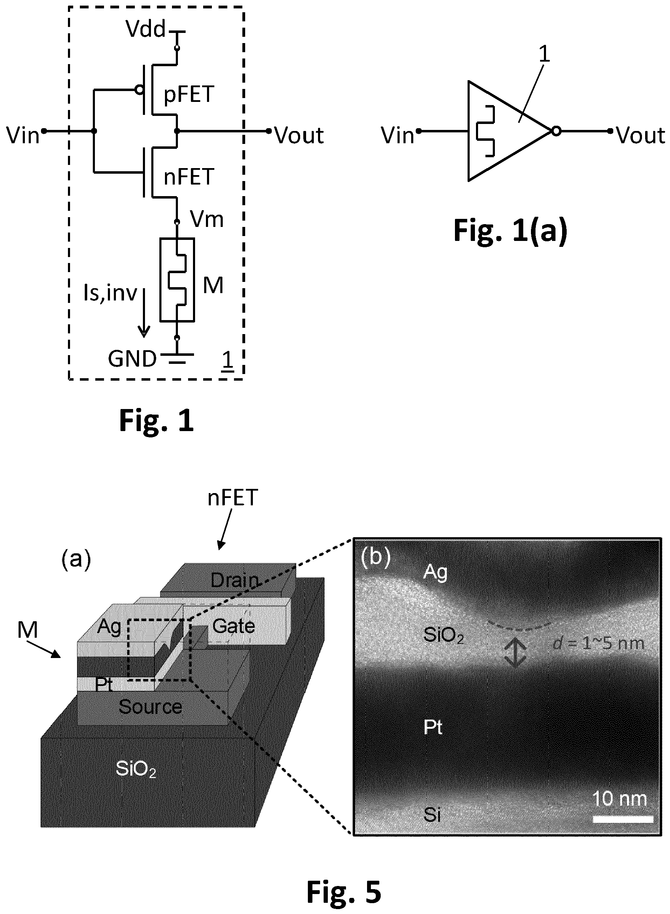

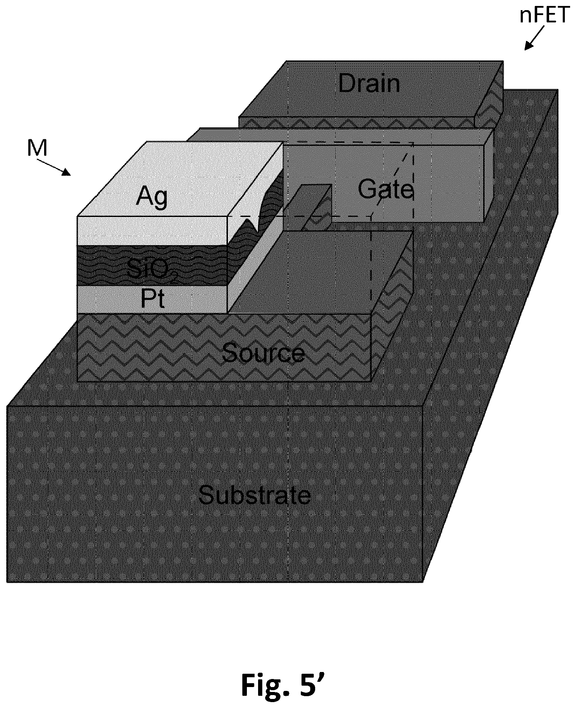

Fig. 5 illustrates a threshold switch in accordance with some embodiments of the invention;
Fig. 5' is an enlarged view of Fig. 5(a);

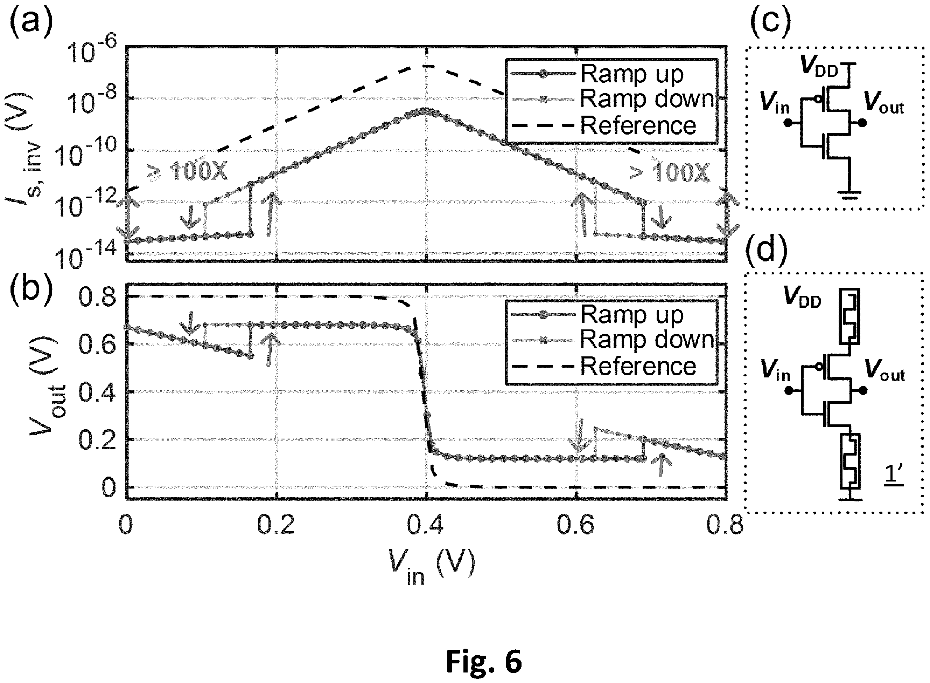

Fig. 6 illustrates a double-sided inverter in accordance with some embodiments of the invention;

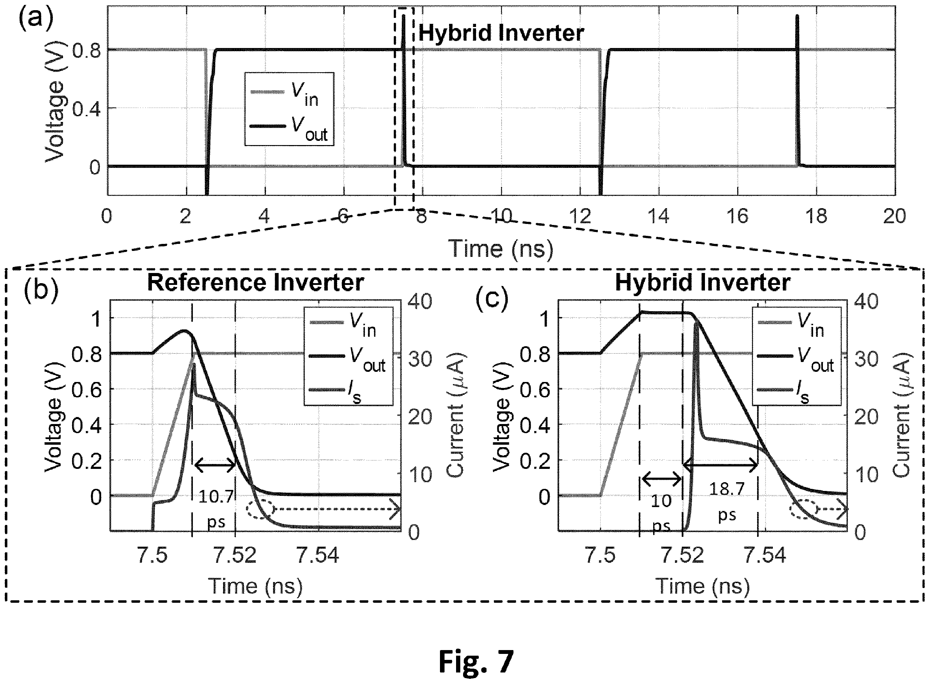

Fig. 7 illustrates the dynamic behavior of the inverter illustrated in Fig. 4(d) and of the reference inverter illustrated in Fig. 4(c);

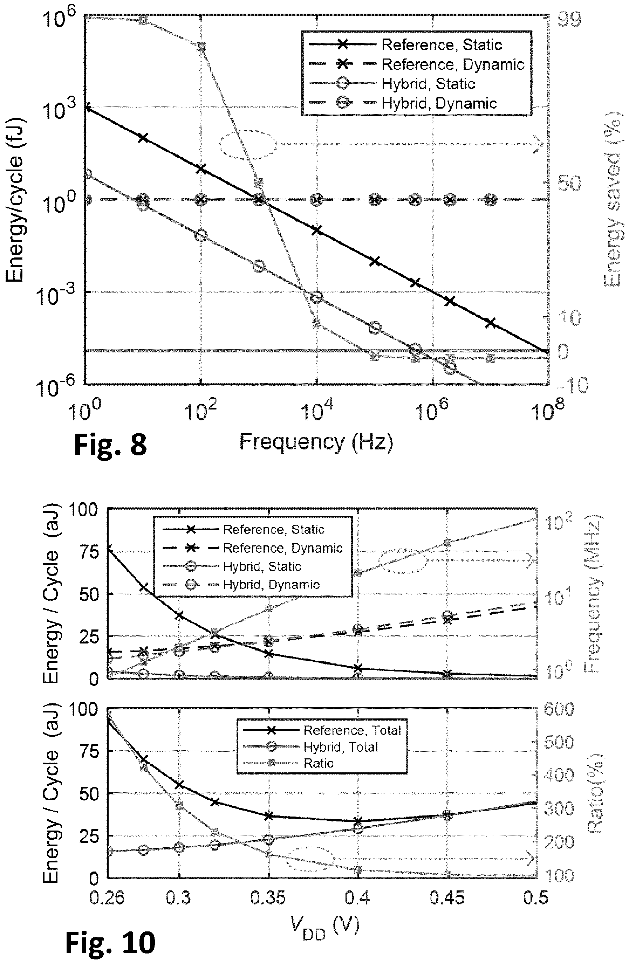

Fig. 8 illustrates the dynamic and static power consumption per cycle of the inverter illustrated in Fig. 4(d) and of the reference inverter illustrated in Fig. 4(c);

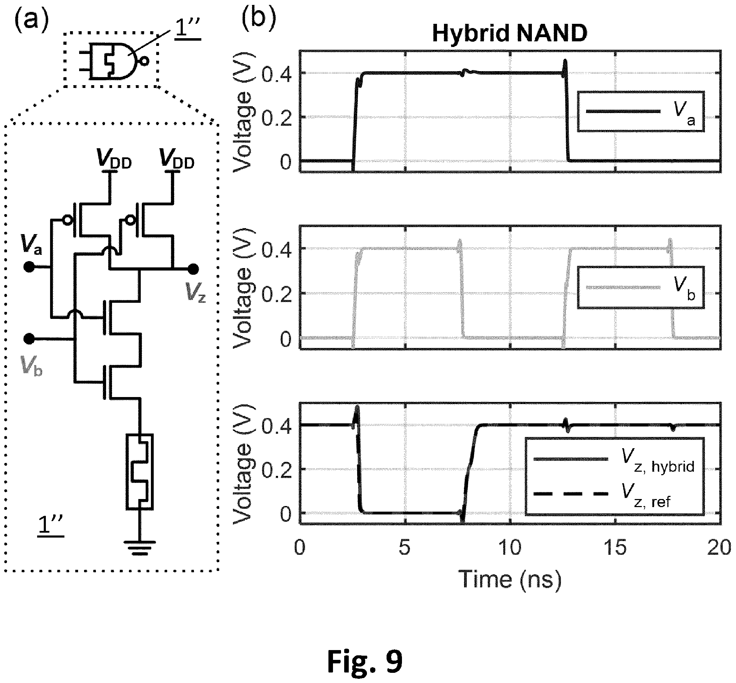

Fig. 9 illustrates the circuit diagram and the timing diagrams of a logic circuit providing a NAND logic function in accordance with some embodiments of the invention;
Fig. 10 illustrates the static power consumption and the dynamic energy per cycle and the total energy per cycle of a NAND circuit illustrated in Fig. 9(a);

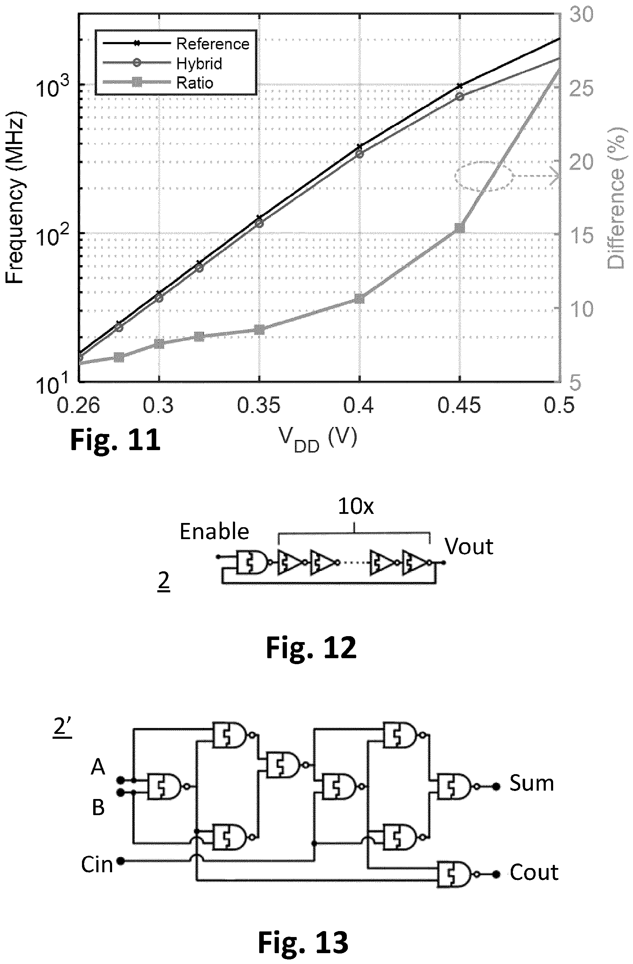

Fig. 11 illustrates the frequency of a ring oscillator in accordance with some embodiments of the invention;
Fig. 12 illustrates a ring oscillator in accordance with some embodiments of the invention;
Fig. 13 illustrates an adder in accordance with some embodiments of the invention;

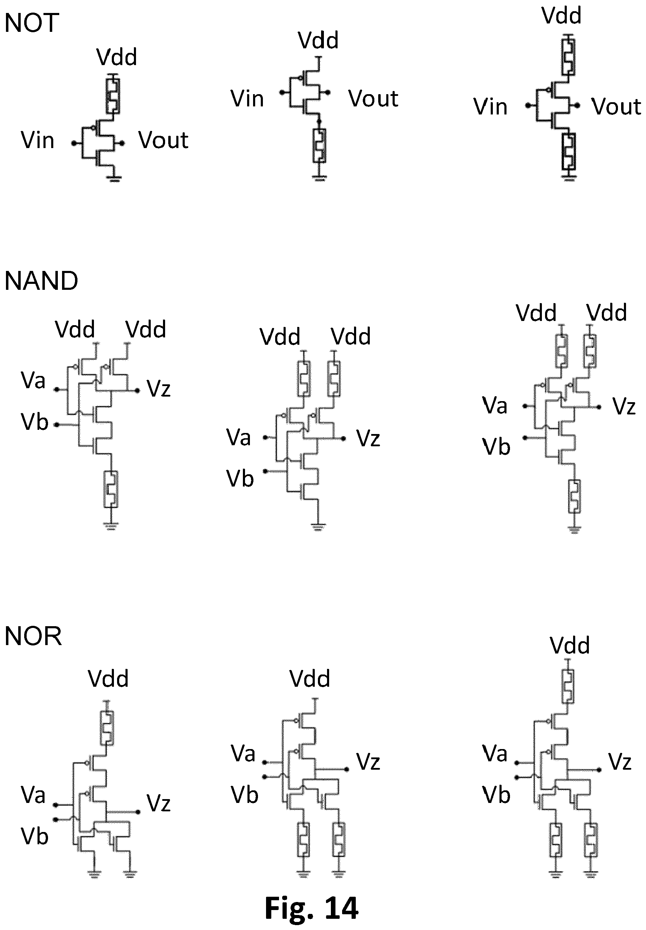

Fig. 14 illustrates circuits in accordance with some embodiments of the invention providing a NOT function, a NAND function or a NOR function.

The figures are only schematic and not to scale. Same reference signs refer to same or similar features. Same schematic elements refer to same or similar features.

### MODE(S) FOR CARRYING OUT THE INVENTION

Fig. 1 illustrates the circuit diagram of a logic circuit in the form of a CMOS inverter 1 (NOT logic function) in accordance with some embodiments of the invention. The source of a p-type field effect transistor pFET is connected to supply voltage Vdd. The drain of the p-type field effect transistor pFET is connected to the drain of a n-type field effect transistor nFET. The source of the n-type field effect transistor nFET is connected to one end of a threshold switch M. The other end of the threshold switch M is connected to ground GND. In some embodiments of the invention (not illustrated in Fig. 1), supply voltage Vdd relates to a positive supply voltage Vdd and ground GND relates to a negative supply voltage Vss. An input voltage Vin is connected to the gate of the p-type field effect transistor pFET and to the gate of the n-type field effect transistor nFET. An output voltage Vout is connected to the drain of the p-type field effect transistor pFET and to the drain of the n-type field effect transistor nFET. The inverter 1 according to Fig. 1 provides a high output voltage Vout in case of a low input voltage Vin, and a low output voltage Vout in case of a high input voltage Vin. The output voltage Vout represents the opposite logic-level of the input voltage Vin.

Fig. 1(a) illustrates the circuit symbol of the inverter 1 illustrated in Fig. 1. The output voltage Vout represents the opposite logic-level of the input voltage Vin.

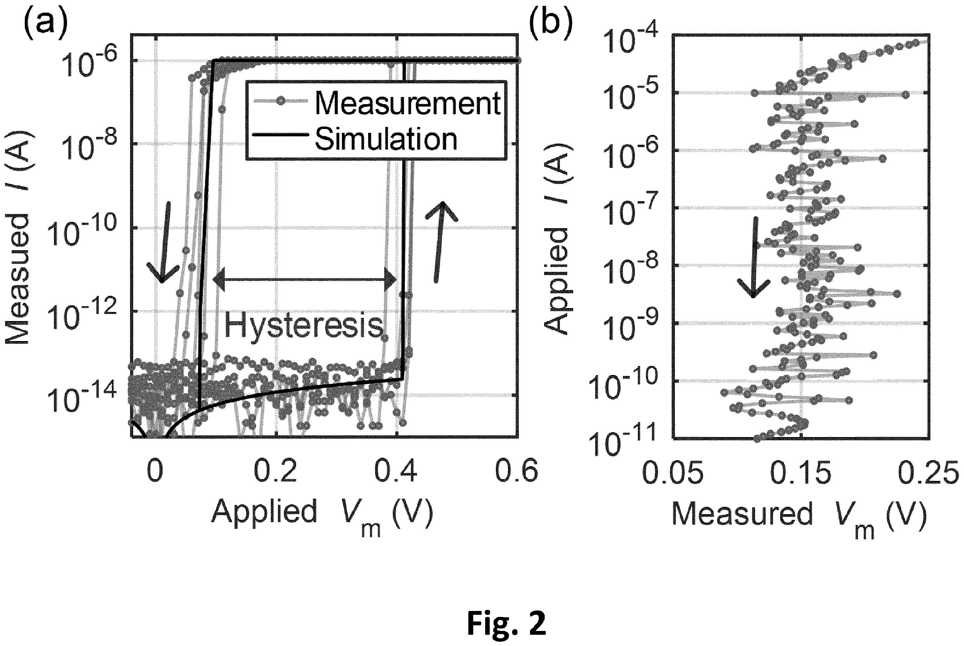

Fig. 2(a) illustrates the Vm-I switching cycle of the threshold switch M in accordance with some embodiments of the invention, particularly in accordance with the embodiment illustrated in Fig. 5 below. The applied voltage Vm is swept at a rate of 10 mV/s. The measured current I through the threshold switch M is plotted against the applied voltage Vm. A current compliance limit of 1 uA (micro Ampere) is applied. Fig. 2(a) illustrates sweeping up the applied voltage Vm from 0 V to 0.6 V, and sweeping down the applied voltage Vm from 0.6 V to 0 V. When sweeping up the applied voltage Vm, at the threshold voltage Vth of about 0.4 V, the threshold switch changes from a high resistances state (HRS) to a low resistance state (LRS). The threshold voltage Vth is engineered to match the supply voltage Vdd of the transistors pFET, nFET. When sweeping up the applied voltage Vm, at the switching point (threshold voltage Vth), the current I through the threshold switch M abruptly increases by a factor of about 10⁸ (10 to the power of 8). When sweeping down, the threshold switch M switches back to HRS at a voltage of about 0.08 V. Particularly, the threshold switch M does not require a reset at negative voltages.

Fig. 2(a) illustrates schematically the Vm-I switching cycle of a measurement and of a simulation computed with Verilog-A using a linear hypothesis (Strukov et al., "The missing memristor found" (in English), Nature, vol. 453, no. 7191, pp. 80-83, May 1 2008; Kvatinsky et al., "VTEAM: A general model for voltage-controlled memristors" IEEE Transactions on Circuits and Systems II: Express Briefs, vol. 62, no. 8, pp. 786-790, 2015). Further simulations with Verilog-A described below confirm proper operation of logic circuits according to the invention and are used to demonstrate proper operation of further logic circuits according to the invention (i.e. the simulations are used for the design of further logic circuits according to the invention). The skilled person will understand that other simulation tools than Verilog-A may be involved or used.

Fig. 2(b) illustrates the Vm-I diagram of the threshold switch M in accordance with some embodiments of the invention. The compliance current I is applied and the threshold switch voltage Vm is measured. The compliance current I is swept down from 100 uA to 10 pA in about 10 s, when starting from the LRS. The threshold switch voltage Vm is essentially constant at about 0.15 V through essentially the applied current range. At LRS, the threshold switch M has a self-adaptive characteristic.

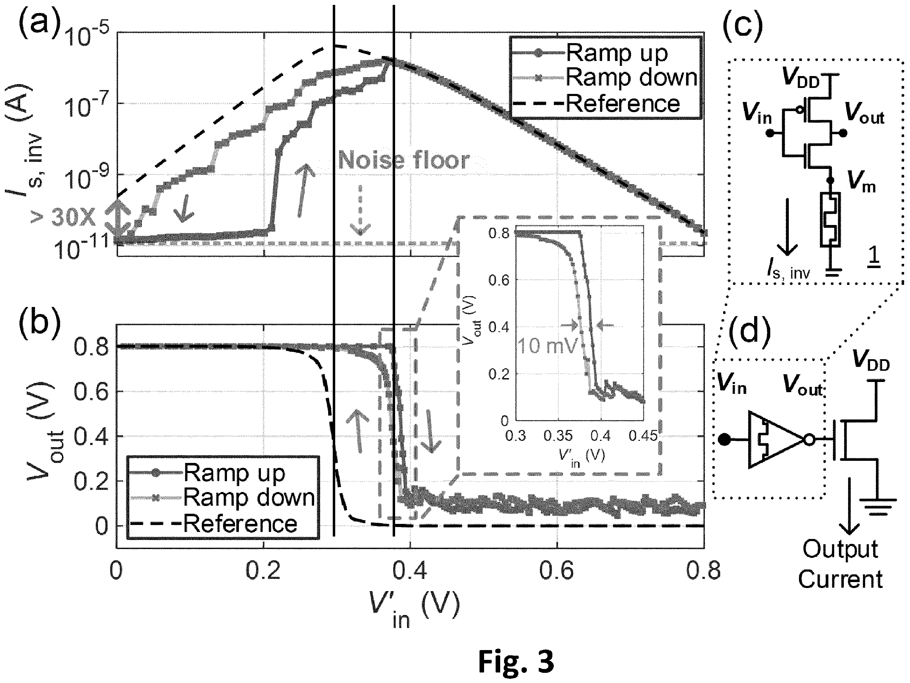

Fig. 3(a) illustrates the measurement of the static current Is,inv of the inverter 1 illustrated in Fig. 1. Fig. 3(b) illustrates the measured output voltage Vout of the inverter 1 illustrated in Fig. 1. Fig. 3(a),(b) illustrate the measurements as a function of Vin', wherein Vin' = Vin + 0.55 V for better readability, as the n-type field effect transistor nFET is in depletion mode and the transition voltage of the inverter 1 is negative. Fig. 3(c) is a copy of the circuit diagram of the inverter 1 illustrated in Fig. 1 for simplifying verification of the following explanations. Fig. 3(d) illustrates the circuit diagram for deriving the inverter output voltage Vout by measuring the output current of the n-type field effect transistor nFET.

Fig. 3(a),(b) include measurements of the inverter 1 according to Fig. 1, as well as measurements of a reference inverter. In the reference inverter, the threshold switch M is replaced by a short circuit. Thus, the reference inverter is a standard inverter as known in the prior art.

For both the inverter 1 according to some embodiments of the invention and for the reference inverter, the measurement illustrated in Fig. 3(a),(b) was performed at a sweeping rate of the input voltage of about 20 mV/s, while keeping the source voltage Vdd at 0.8 V. Fig. 3(a) shows that the inverter 1 according to the invention has a reduction of the leakage current by more than 30 times with respect to the reference inverter, which is only limited by the noise floor of about 10 pA of the measurement setup.

As illustrated in Fig. 3(b), the inverter 1 according to the invention has a switching behaviour which is essentially free of hysteresis. At about Vin' of 0.39 V, a small difference of approximately 10 mV can be identified between the sweep up ramp and the sweep down ramp, which is magnified in the inset of Fig. 3(b). The hysteresis is much smaller than the about 40 mV switching slope of the reference inverter (about 0.27^{~}0.31 V). Accordingly, it is correct to say that the inverter 1 according to the invention is essentially free of hysteresis.

As illustrated in Fig. 3(d), the output voltage Vout is extracted from the measured output-current and I-V-characteristics of an additional nFET. In the range from Vin' = 0.4 V to Vin' = 0.8 V, the output voltage Vout is about 0.12 V, which is approximately equal to the voltage Vm dropping off across the threshold switch M. Thus, the threshold switch M adapts its parameters such as the resistance based on the current for keeping a constant voltage of about 0.12 V, similarly as illustrated in Fig. 2(b).

Referring to the reference inverter, as illustrated in Fig. 3(a), when sweeping up the input voltage Vin', the resistance of the n-type field effect transistor nFET decreases, while the resistance of the p-type field effect transistor pFET increases. At an input voltage Vin' which depends on characteristics of the nFET, pFET, the output voltage Vout decreases. At about input voltage Vin' = 0.29 V, the resistances of the nFET and pFET are equal, the current Is,inv through the reference inverter reaches its maximum, and the output voltage Vout reaches 0.4 V, which is half of supply voltage Vdd = 0.8V as illustrated in Fig. 3(b). When sweeping up further the input voltage Vin', the resistance of the nFET further decreases, the resistance of the pFET further increases, the current Is,inv through the reference inverter decreases again, and the output voltage Vout further decreases until it reaches about 0 V at an input voltage Vin' which depends on characteristics of the nFET, pFET.

Referring to the inverter 1 according to some embodiments of the invention as illustrated in Fig. 3(c) or Fig. 1, when sweeping up the input voltage Vin', the resistance of the n-type field effect transistor nFET decreases, while the resistance of the p-type field effect transistor pFET increases. As illustrated in Fig. 3(a), at an input voltage Vin' of about 0.2 V (at this point, the voltage on the threshold switch M reaches the switching threshold), the current Is,inv rapidly increases and continues to increase with increasing input voltage Vin'. At an input voltage Vin' of about 0.35 V the resistances of the pFET and the nFET are about equal Is,inv reaches its maximum, and the output voltage Vout changes from Vdd =0.8 V to about 0.12 V (the voltage differs from the voltage of about 0.15 V disclosed in connection with Fig. 2(b) because of device to device and cycle to cycle variances). Similarly, when sweeping down the input voltage Vin', when Vin' approaches about 0.35 V, Is,inv reaches its maximum and the output voltage Vout changes from about 0.12 V to the supply voltage Vdd = 0.8V. In either case, the output voltage Vout changes its value when Is,inv is at its maximum at the input voltage of about 0.35 V. Hence, the output voltage Vout shows essentially no hysteretic behaviour in the range of the input voltage Vin' where the inverter 1 changes its logic state.

Fig. 4(a) illustrates the simulation of the static current Is,inv of the inverter 1 illustrated in Fig. 1. Fig. 4(b) illustrates the simulated output voltage Vout of the inverter 1 illustrated in Fig. 1. Fig. 4(a),(b) illustrate the simulations as a function of Vin (contrary to the Fig. 3, which includes depletion mode transistors, standard MOSFET are used and Vin instead of Vin' is used), as the n-type field effect transistor nFET is in depletion mode and the transition voltage of the inverter 1 is negative. Fig. 4(c) is the circuit diagram of the reference inverter according to the state of the art. Fig. 4(d) is a copy of the circuit diagram of the inverter 1 illustrated in Fig. 1 for simplifying verification of the following explanations.

The simulations illustrated in Fig. 4(a),(b) correspond very well with the measurements illustrated in Fig. 3(a),(b). Because the simulations do not suffer from measurement noise, the simulation illustrated in Fig. 4(b) confirms that the leakage current is lowered by a factor of 100 compared to the reference inverter. Furthermore, the simulation confirms that the output voltage Vout shows no hysteretic behaviour in the voltage range of the input voltage Vin' where the inverter switches its logic state. The measurement shows a small difference (^{∼}5 mV) of the transition voltage at Vin=0.38 V because of a small difference in the resistance during sweep-up and sweep-down, which is due to cycle-to-cycle variance, which is small enough to have negligible impact on circuit operation. Instead the hysteresis occurs between an input voltage Vin' of about 0.72 V during sweeping up, and an input voltage Vin' of about 0.7 V during sweeping down. Even though the nFET exhibits a small hysteresis, its impact on the *I-V* curve of the inverter is shifted out of the voltage range of interest. By engineering the threshold switch M and pFET/nFET parameters correctly, the remaining hysteresis window does not interfere with the static operating points at the input voltage Vin' of about 0.05 V and the input voltage Vin' of about 0.8 V. Furthermore, a switching layer of the threshold switch may be engineered as regards material (doping), process treatment (annealing), thickness, area, active metallic surface potential, contact resistance, etc. Furthermore, device and circuit co-design may include matching the parameters of the threshold switch such as Roff and threshold voltage Vth with the source voltage Vdd as well as the transistor's pFET, nFET leakage current.

Fig. 4' illustrates schematically a logic circuit in accordance with various embodiments of the invention. The logic circuit corresponds to the inverter illustrated in Fig. 4. As illustrated in Fig. 4', the input voltage Vin' varies between 0V and Vdd, and the output voltage varies between Vdd and 0V. Thus, the skilled person understands that any of the specific values such as a supply voltage Vdd of about 0.8V must be interpreted as specific working embodiments of the invention, wherein the invention is not limited to these specific values. Accordingly, any of the disclosed specific values such as the supply voltage Vdd of about 0.8V must be interpreted as being selected from a respective range such as from a range starting with a value of about 0.4V or below up to a value of 5V or above for the case of the supply voltage Vdd. In other words, the specific values may be adapted in accordance with specific requirements. For example, the supply voltage Vdd may have any value of from about 0.4V or below up to any value of 5V or above.

Fig. 5(a),(b) illustrate a threshold switch M in accordance with some embodiments of the invention. The threshold switch M is connected to the source of a n-type field effect transistor nFET. The nFET is in accordance with the prior art. The threshold switch M and the nFET constitute a hybrid nFET. The threshold switch M and the nFET constitute a hybrid nFET. The threshold switch M includes a Ag or Cu layer (Cu is more CMOS friendly than Ag), which is deposited on a SiO2 layer, which is deposited on a Pt layer, which is connected to the source of the nFET. The top electrode, i.e. the Pt layer, has a unique 3D tip to confine the operation of the threshold switch M and to limit the leakage current to the tip of the apex. The threshold switch M provides memristive operation. Fig. 5(b) illustrates the fabricated threshold switch M in a cross-sectional high-resolution transmission electron microscopy (HRTEM) image. The threshold switch has an active device are of less than 20 nm x 20 nm. Accordingly, the threshold switch can be easily integrated on the source or the drain of any FET. The distance d between the Ag layer and the Pt layer at the apex of the 3D tip can be accurately controlled during fabrication to adjust the switching threshold voltage. The small footprint is particularly beneficial for co-integration with advanced MOSFET technology nodes. The CMOS compatible SiO2 layer or matrix within the threshold switch M allows for fabrication in the back end of line (BEOL) process. The threshold switch provides the switching cycle illustrated in Fig. 2, namely the measured I-V hysteresis during voltage sweep illustrated in Fig. 2(a) and the measured voltage during the current sweep illustrated in Fig. 2(b), which vertical characteristic shows a unique non-resistive characteristic.

Fig. 5' is an enlarged view of Fig. 5(a).

Fig. 6 illustrates a double-sided inverter in accordance with some embodiments of the invention. Fig. 6 is based on a calibrated simulation. Fig. 6 includes results of the inverter in accordance with the invention as illustrated in Fig. 6(d) and results of a reference inverter of the prior art as illustrated in Fig. 6(c). The inverter in accordance with some embodiments of the invention includes a threshold switch M in the pull-down path of the nFET and a threshold switch M in the pull-up path of the pFET. Fig. 6(a) illustrates the Is,inv-Vin' graph, wherein Vin' is swept up and swept down. Clearly, leakage current is reduced by a factor 100 both in the low voltage and the high-voltage regimes (which relate to logic states). Fig. 6(b) illustrates the Vout-Vin' graph, wherein Vin' is swept up and swept down. The threshold switches M in the pull-down path and the pull-up path introduce two small hysteresis windows at input voltage Vin' of about 0.16 V and of about 0.69 V during sweep up, and at input voltage Vin' of about 0.63 V and of about 0.1 V during sweep down. Both hysteresis windows (0.1^{∼}0.16 V, 0.63^{∼}0.69 V) are outside the voltage range of relevance.

For the sake of simplicity, the reminder of this disclosure is limited to arranging the threshold switch M in the pull-down path as illustrated in Fig. 4. However, the skilled person will understand that arranging a threshold switch M also in the pull-up path or to both pull-up and pull-down path also corresponds to some embodiments of the invention.

Fig. 7 illustrates the dynamic behavior of the inverter illustrated in Fig. 4(d) and of the reference inverter illustrated in Fig. 4(c). Fig. 7 is based on a simulation of a 22 nm SOI platform. Fig. 7(a) shows the Vin-Vout sequence. The inverter in accordance with the invention provides the expected inversion of the input. Fig. (b),(c) show a magnification of the falling edge of the inverter in accordance with the invention and of the reference inverter. The inverter in accordance with the invention has an extra delay of about 10 ps and a prolonged transition time. When Vin switches from Vdd to 0 V, Vout goes from 0 V to Vdd, wherein the threshold switch M remains in its HRS and essentially no difference can be identified with respect to the reference inverter. On the other hand, when Vin switches from 0 V to Vdd, the threshold switch M switches to the LRS of about 5 kOhm after a delay of about 10 ps, which is indicated by a rise of Is, and the transition time increases from about 10.7 ps to about 18.7 ps.

Fig. 8 illustrates the dynamic and static power consumption per cycle of the inverter illustrated in Fig. 4 (d) and of the reference inverter illustrated in Fig. 4(c). In the inverter in accordance with some embodiments of the invention, the static power consumption is reduced by a factor of about 150, while the dynamic power consumption is increased by only about 5%. The energy saved is shown with respect to the right vertical axis. Below 100 kHz, static power consumption dominates over dynamic power consumption and total power consumption of the inverter in accordance to some embodiments of the invention is lower than the total power consumption of the reference inverter. Accordingly, the inverter in accordance to some embodiments of the invention is well suited for sensing with low sampling rates for IoT applications. At a frequency of 1 kHz, more than 50% of energy can be saved.

Fig. 9(a) illustrates the circuit diagram of a logic circuit providing a NAND logic function in accordance with some embodiments of the invention. Fig. 9(b) illustrates the timing diagrams of the input signals Va, Vb and of the output signal Vz of the NAND circuit. The NAND circuit in accordance with some embodiments of the invention functions properly.

Following the same approach as for low leakage IoT circuit, below embodiments of the invention relating to near-threshold computing, for example in portable embedded systems (PeS), are disclosed. Because of lowering the supply voltage Vdd from 0.8 V by more than a half, for the best performance-energy balance, transistors with lower threshold voltage and higher leakage are selected. As consequence, the threshold switching voltage Vth of the threshold switch M is adjusted to match the transistor characteristics. The parameters of the present embodiments are as follows: IoT: Vdd 0.8 V, Vth 0.4 V, HRS 17 TOhm, LRS 5 kOhm; near-threshold computing: Vdd 0.26^{∼}0.45 V, Vth 0.17^{∼}0.26 V, HRS 8 GOhm, LRS 5kOhm. The parameters may be chosen differently and may depend on the technology involved, such as the CMOS technology. For both models, model parameters have been experimentally verified with fabricated devices. In addition, the threshold voltage Vth is adjusted to best match the source voltage Vdd. However, process variation and random telegraph noise do not scale well with Vdd. When the source voltage Vdd is too low, these factors will limit the reliability and makes circuits impractical. For this reason, the source voltage Vdd range was limited down to 0.26 V.

Figs. 8, 9 relate to IoT. Figs. 10 and subsequent relate to PeS.

Fig. 10(a) illustrates the static power consumption and the dynamic energy per cycle of the NAND circuit in accordance with some embodiments of the invention and of a reference NAND circuit in accordance with the prior art. The graph illustrates energy per cycle as a function of supply voltage Vdd. Energy per cycle is defined as the average over all transitions from each of the four input states to another state. Static power is the average over four input states. The right vertical axis illustrates the ratio of the energy per cycle of the NAND circuit in accordance with some embodiments of the invention and the reference NAND, which is reduced by more than 90%. In addition, the switching delay of the threshold switch M also eliminates the short-circuit current. As a result, the dynamic energy per cycle of the NAND circuit in accordance with some embodiments of the invention at Vdd < 0.4 V is lower than that of the reference NAND.

Fig. 10(b) illustrates the total energy per cycle as a function of the supply voltage Vdd. For the reference NAND circuit, the total energy per cycle reaches its minimum of about 33.4 aJ (highest efficiency) at source voltage Vdd of about 0.4 V. For the NAND circuit in accordance with some embodiments of the invention, the lowest total energy per cycle is about 15.8 aJ at source voltage Vdd of about 0.26V, which is more than 52% smaller. This corresponds to an efficiency gain of about 111%, which is shown on the right vertical axis. The source voltage Vdd was limited to about 0.26 V for practical circuit concerns, the performance gain can be expected to be even higher at lower source voltage Vdd. By limiting the source voltage Vdd to about 0.26 V, one can further optimize the energy-frequency. For instance, if the threshold voltage of the nFET is lowered and the FET leakage is increased by 10%, the delays will be reduced by approximately 10%, making up the extra delay induced by the threshold switch M. The efficiency gain can be expected to be reduced to 84%.

Fig. 12 illustrates in accordance with some embodiments of the invention, particularly related to near-threshold computing, a ring oscillator which includes eleven of the inverters as illustrated in Fig. 4(d) in the form of ten inverters and one NAND for providing an enable function. Contrary to a ring oscillator in accordance with some embodiments of the invention, a reference inverter in accordance with the prior art includes eleven inverters as illustrated in Fig. 4(c).

Fig. 11 illustrates the frequency of the ring oscillator in accordance with some embodiments of the invention and of the reference ring oscillator. The right vertical axis illustrates the frequency difference in percent. The ring oscillator in accordance with some embodiments of the invention has a slight penalty in terms of delay for the whole range of the source voltage Vdd. The delay remains below 10% for source voltages Vdd < 0.38 V, which is more interesting as regards reduction of power consumption.

Fig. 13 illustrates the circuit diagram of a full adder 1''' in accordance with some embodiments of the invention. The full adder 1''' is constructed using NAND circuits as illustrated in Fig. 9(a). A reference circuit is constructed using NAND circuits in accordance with the prior art (without threshold switches M in the NAND circuits). In accordance with simulations at supply voltage of Vdd = 0.4 V and at a frequency of 20 MHz, which is the optimal operating point of the reference circuit, dynamic power consumption and static power consumption are as follows: reference circuit: static power 1.12 nW, dynamic power 6.54 nW; circuit in accordance with the invention: static power 0.059 nW, dynamic power 6.67 nW. The dynamic power is the average of all transitions from each of the 8 input states to one of the 4 output combinations, whereas the static power is the average of the 8 inputs. The static power of this adder is reduced by 94.7% and the total efficiency is increased by 13.9%. Note that the reference circuit is already operating at the optimum supply voltage Vdd with the highest efficiency possible, while more gain in efficiency could be expected if source voltage Vdd is lowered for the circuit in accordance with the invention.

Fig. 14 illustrates circuits in accordance with some embodiments of the invention providing a NOT function, a NAND function or a NOR function. As illustrated in Fig. 14, the threshold switch M is arranged in the pull-up path, in the pull-down path or both in the pull-up path and in the pull-down path.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims. In the description and the figures, the term "hybrid" indicates embodiments of logic circuits in accordance with the invention, and the term "reference" indicates embodiments of logic circuits in accordance with the prior art.

## Claims

1. A logic circuit (1, 1', ...), comprising:
at least two transistors (pFET, nFET) which are configured for providing a logic function, and
at least one voltage-controlled threshold switch (M), which is arranged in at least one of the pull-up path and the pull-down path of at least one of the at least two transistors (pFET, nFET).

2. The circuit (1,1', ...) of the previous claim, wherein at least one of the at least one voltage-controlled threshold switch (M) is configured for changing its state from a high resistance state to a low resistance state when the applied voltage is higher than a first predefined threshold voltage.

3. The circuit (1, 1', ...) of one of the previous claims, wherein at least one of the at least one voltage-controlled threshold switch (M) is configured for changing its state from a low resistance state to a high resistance state when the applied voltage is lower than a second predefined threshold voltage.

4. The circuit (1, 1', ...) of one of the previous claims, wherein at least one of the at least one voltage-controlled threshold switch (M) is configured for maintaining over a range of applied currents an essentially constant voltage.

5. The circuit (1, 1', ...) of one of the previous claims, wherein the voltage-controlled threshold switch (M) includes a stack of an active layer arranged between a first electrode and a second electrode, wherein the active layer is in particular an oxide-based layer, a nitride-based layer or a solid-state electrolyte, wherein in case of an oxide-based layer the active layer is selected from a material which includes in particular silicon dioxide, tantalum oxide, tungsten oxide, hafnium oxide or titanium oxide, wherein in case of a nitride-based layer the active layer is selected from a material which includes in particular a stack of titanium nitride and aluminum nitride and titanium nitride, a stack of titanium nitride and aluminum nitride and aluminum, or a stack of tantalum nitride and gallium aluminum nitride and aluminum, wherein in case of a solid-state electrolyte the active layer is selected from a material which includes a polymer.

6. The circuit (1, 1', ...) of one of the previous claims, wherein the voltage-controlled threshold switch (M) includes a stack of an active layer arranged between a first electrode and a second electrode, wherein one or more of the first electrode and the second electrode includes a material which is selected from one or more of silver, copper, tungsten, cobalt, platinum and alloys thereof.

7. The circuit (1, 1', ...) of one of the previous claims, wherein the voltage-controlled threshold switch (M) includes a resistive switching device, in particular a conductive-bridging-random-access-memory-type memristor or another electrochemical metallization memory device or a valence change mechanism device.

8. The circuit (1, 1', ...) of one of the previous claims, wherein the voltage-controlled threshold switch (M) includes a 3D structure comprising an electrode having a 3D tip for confining operation of the threshold switch (M) or an insulating layer with a hole in particular in the form of a 2D layer.

9. The circuit (1, 1', ...) of one of the previous claims, wherein the voltage-controlled threshold switch (M) includes silver-doped hafnium dioxide, copper / hafnium dioxide, silver / titanium dioxide, copper sulfide, silver / amorphous silicon, silver telluride / titanium nitride / titanium dioxide / titanium nitride, wolfram / copper sulfide and combinations thereof.

10. The circuit (1, 1', ...) of one of the previous claims, wherein the voltage-controlled threshold switch (M) comprises an unipolar, abrupt, reversible, and electrically triggered resistance switch between two stable resistance states.

11. The circuit (1, 1', ...) of one of the previous claims, wherein the voltage-controlled threshold switch (M) has an active area of less than 20 nm x 20 nm.

12. The circuit (1, 1', ...) of one of the previous claims, configured for providing a hysteresis free operation.

13. The circuit (1, 1', ...) of one of the previous claims, configured for providing a NOT logic function and in particular comprising a p-type field effect transistor (pFET) and a n-type field effect transistor (nFET) and.

14. The circuit (1, 1', ...) of one of the previous claims, configured for providing a NAND logic function or a NOR logic function and in particular comprising at least two p-type field effect transistors (pFET, pFET') and at least two n-type field effect transistors (nFET, nFET').

15. An Internet-of-Things device or a near threshold computing device including one or more circuits (1, 1', ...) of one of the claims 1 to 13.
